# EUROPEAN PATENT APPLICATION

(11) **EP 3 118 347 A1**
(43) Date of publication of application: **18.01.2017**
(21) Application number: 15761219.3
(22) Date of filing: 03.03.2015
(51) Int. Cl.: C23C 14/08, C23C 14/06, H01L 21/316, H01L 41/187, H01L 41/316, H01L 41/319

(54) **METHOD FOR MANUFACTURING MULTILAYER FILM, AND MULTILAYER FILM**

(30) Priority: 10.03.2014 JP 2014046814
(71) Applicant: ULVAC, Inc., Chigasaki-shi, Kanagawa 253-8543 (JP)
(72) Inventor: KOBAYASHI Hiroki, Chigasaki-shi Kanagawa 253-8543 (JP); HENMI Mitsunori, Chigasaki-shi Kanagawa 253-8543 (JP); HIROSE Mitsutaka, Chigasaki-shi Kanagawa 253-8543 (JP); TSUKAGOSHI Kazuya, Chigasaki-shi Kanagawa 253-8543 (JP); KIMURA Isao, Chigasaki-shi Kanagawa 253-8543 (JP); SUU Koukou, Chigasaki-shi Kanagawa 253-8543 (JP)
(74) Representative: Zacco GmbH
(86) International application number: PCT/JP2015/056238
(87) International publication number: WO 2015/137198

(57) **Abstract**

A method of manufacturing a multi-layered film of the invention includes: forming an electroconductive layer (3) on a substrate (2, 31); forming a seed layer (4) including an oxidative product having a perovskite structure so as to coat the electroconductive layer (3) by a sputtering method; and forming a dielectric layer (5) so as to coat the seed layer (4).

## Description

### TECHNICAL FIELD

The present invention relates to a method of manufacturing a multi-layered film and a multi-layered film.

This application claims priority from Japanese Patent Application No. 2014-046814 filed on March 10, 2014, the contents of which are incorporated herein by reference in their entirety.

### BACKGROUND ART

Currently, a piezo element using a ferroelectric substance such as lead zirconate titanate (Pb(Zr,Ti)O₃: PZT) is applied to MEMS (Micro Electro Mechanical Systems) technology, for example, an inkjet head, an acceleration sensor, or the like.

Particularly, a PZT film has been attracted attention and actively researched by various organizations (Patent Documents 1 to 3).

### PRIOR ART DOCUMENTS

### PATENT DOCUMENTS

[Patent Document 1] Japanese Unexamined Patent Application, First Publication No. 2007-327106
[Patent Document 2] Japanese Unexamined Patent Application, First Publication No. 2010-084180
[Patent Document 3] Japanese Unexamined Patent Application, First Publication No. 2003-081694

### SUMMARY OF INVENTION

### PROBLEMS TO BE SOLVED BY THE INVENTION

However, in the case of forming a high density PZT thin film, a temperature margin to form a film is narrow, there is a problem in that stable mass production is difficult.

The invention was conceived in view of the above-described conventional circumstances and has a first object thereof to provide a method of manufacturing a multi-layered film, which has a wider temperature margin to form a film.

Additionally, the invention has a second object thereof to provide a multi-layered film which has a wider temperature margin to form a film and provides excellent withstand voltage characteristics.

### MEANS FOR SOLVING THE PROBLEMS

The inventors are working on various researches in order to improve withstand voltage characteristics of a PZT film.

Hereinafter, a conventional situation before the invention is achieved by the inventors will be described.

Firstly, the inventors have focused attention on a film deposition temperature which is one of the conditions of forming a PZT film, and have researched a withstand voltage of a manufactured PZT film and an amount of Pb.

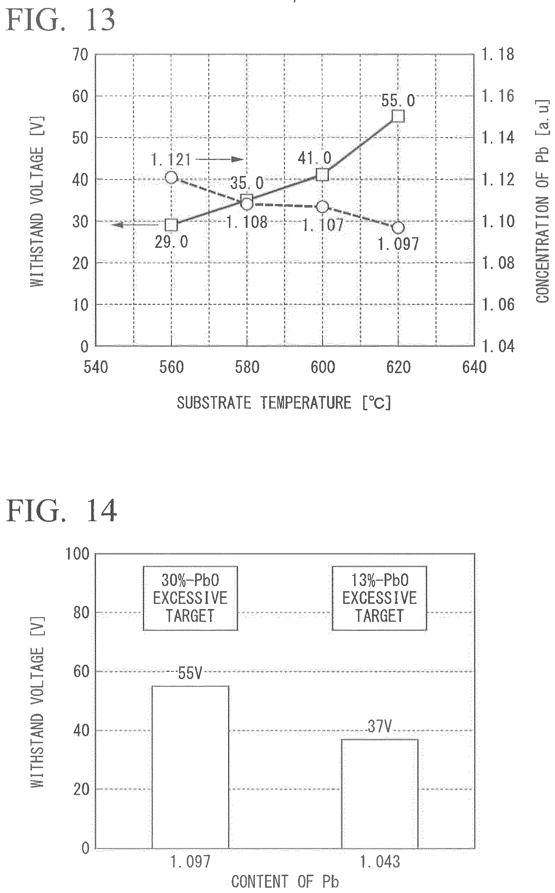

FIG. 13 is a chart showing the withstand voltages and the amounts of Pb of the PZT films which are produced in various film deposition temperatures.

The x-axis represents the film deposition temperature, the left-side y-axis represents the withstand voltage, and the right-side y-axis represents the amount of I'b.

The mark "□" represents the withstand voltage, and the mark "○" represents the amount of Pb.

It is understood that from FIG. 13, with an increase in the film deposition temperature, the withstand voltage has a tendency to increase, but the amount of Pb has a tendency to decrease.

According to the experimental results, the inventors presumed that it is possible to realize a further high withstand voltage by reducing the amount of Pb at the film deposition temperature of 620°C.

FIG. 14 is a graph showing the research results of dependency of the amounts of Pb with respect to withstand voltages in consideration of the aforementioned FIG. 13.

PZT films were produced in the same film forming condition (film deposition temperature: 620°C) with the exception that two targets having the amounts of Pb different from each other (the left side: 30%-PbO excessive target, and the right side: 13%-PbO excessive target) are used; and the amounts of Pb included in the films and the withstand voltages thereof were evaluated.

As shown in FIG. 14, as a result of using the two targets, the amount of Pb included in the PZT film can be reduced (from 1.097 to 1.043 (a.u.)).

However, it was determined that the withstand voltage does not increase, conversely, remarkably decreases (from 55 to 37 V).

It was apparent from the above results that the amount of Pb included in the PZT film is not correlated with the withstand voltage thereof.

Next, the inventors have focused attention on the film structure of the formed PZT film, and have researched the relationship between the film structure and the withstand voltage of the PZT film.

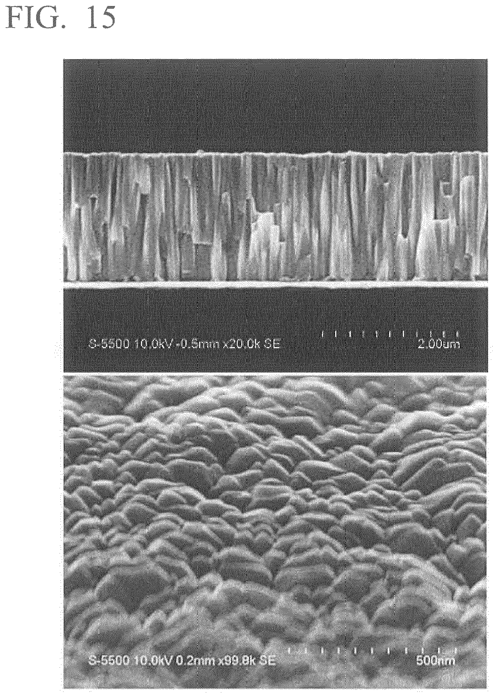

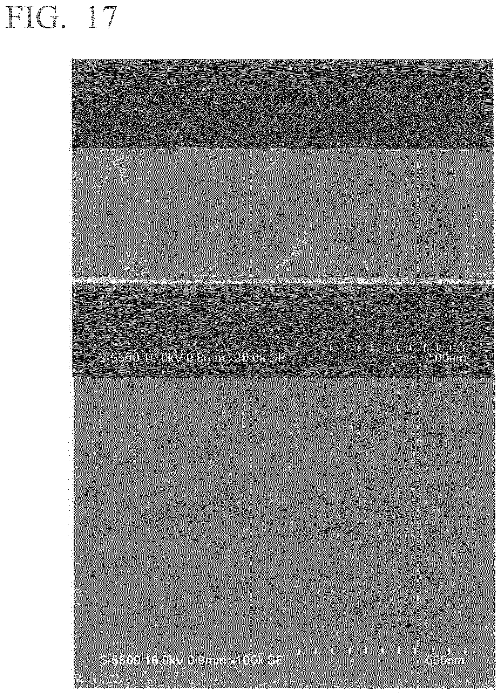

FIGS. 15 to 17 are SEM photographs showing examples. In examples, PZT films are produced under various film forming conditions and the surface morphology of the films varies.

The pictures which are located at the upper positions of FIGS. 15 to 17 show the cross-section of the PZT film, and the pictures which are located at the lower positions of FIGS. 15 to 17 show the top surface of the PZT film.

Table 1 shows the surface roughness (RMS), the density, and the withstand voltage of the PZT films shown in FIGS. 15 to 17.

The surface roughness (RMS) was measured by use of an AFM (Atomic Force Microscope).

The density was determined according to the difference between the weight before dissolving the PZT film and the weight after the PZT film was completely dissolved by use of acid.

The withstand voltage was determined by I-V measurement.

**(Table 1)**

| PZT FILM | FIG. 15 | FIG. 16 | FIG. 17 |
|---|---|---|---|
| SURFACE ROUGHNESS RMS [nm] | 10.2 | 6. 3 | 1. 9 |
| DENSITY [%] | 90.7 | 93.9 | 92.2 |
| WITHSTAND VOLTAGE [V] | +30,-30 | +61, -60 | +47,-36 |

Initially, the inventors presumed that a large withstand voltage can be realized by improving the surface morphology of the PZT film, that is, due to that the surface roughness RMS can be reduced, and formed three types of the PZT films which have surface roughnesses different from each other as shown in Table 1.

However, it was clearly understood from Table 1 that, even where the surface roughness of the PZT film is reduced, that is, even where the surface morphology is improved, it is not necessarily the case that the withstand voltage of the PZT is improved.

In contrast, it was determined that, as the density of the PZT film is large, the withstand voltage is high.

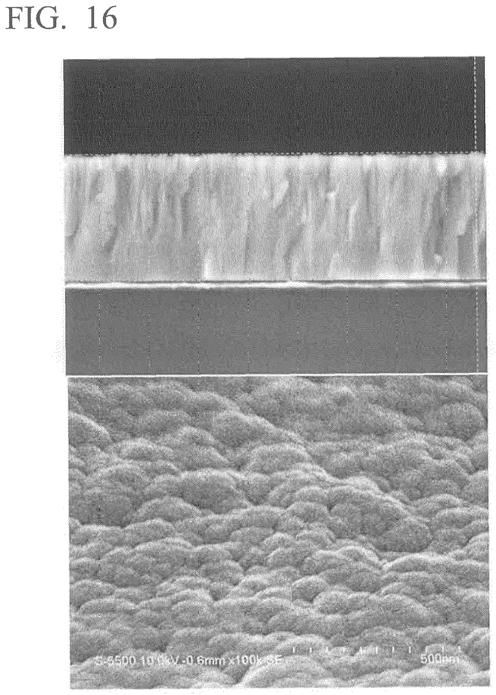

However, in the case of forming a high density PZT thin film shown in FIG. 16, since a temperature margin to form a film is only approximately 80°C, stable mass production was difficult.

The inventors achieve the invention in consideration of the aforementioned knowledge.

A method of manufacturing a multi-layered film according to a first aspect of the invention includes at least the following step A, step B, and step C.

That is, the method of manufacturing a multi-layered film according to the first aspect of the invention includes: forming an electroconductive layer on a substrate (step A); forming a seed layer including an oxidative product having a perovskite structure so as to coat the electroconductive layer by a sputtering method (step B); and forming a dielectric layer so as to coat the seed layer (step C).

In the method of manufacturing a multi-layered film according to the first aspect of the invention, when the seed layer is formed (step B), the seed layer may be formed so that the oxidative product includes lanthanum (La), nickel (Ni), and oxygen (O).

In the method of manufacturing a multi-layered film according to the first aspect of the invention, when the dielectric layer is formed (step C), a relational expression of Td ≤ 500°C may be satisfied where a substrate temperature is defined as Td (dielectric) when the dielectric layer is formed.

In the method of manufacturing a multi-layered film according to the first aspect of the invention, when the seed layer is formed (step B), a relational expression of Ts<Td may be satisfied where a substrate temperature is defined as Ts (seed).

A multi-layered film according to a second aspect of the invention is a multi-layered film formed by use of the method of manufacturing a multi-layered film according to the aforementioned first aspect, in which an electroconductive layer made of platinum (Pt), a seed layer including lanthanum (La), nickel (Ni), an oxygen (O), and a dielectric layer are at least arranged in order on a main surface side of a substrate made of silicon.

### Effects of the Invention

According to the aspects of the invention, in the step B, an oxidative product having a perovskite structure is formed as the seed layer by the sputtering method.

Consequently, when a dielectric film is formed on the seed layer, it is possible to form a dielectric film having a perovskite structure at a lower temperature while reducing generation of a different phase.

For this reason, the invention can provide the method of manufacturing a multi-layered film which has a wider temperature margin.

Furthermore, according to the aspects of the invention, since at least the electroconductive layer made of platinum (Pt), the seed layer including lanthanum (La), nickel (Ni), and oxygen (O), and the dielectric layer are disposed in this order, it is possible to provide the multi-layered film having excellent withstand voltage characteristics.

### BRIEF DESCRIPTION OF THE DRAWINGS

FIG. 1 is a cross-sectional view showing one configuration example of a multi-layered film according to an embodiment of the invention.
FIG. 2A is a cross-sectional view showing a process of manufacturing the multi-layered film according to the embodiment of the invention.
FIG. 2B is a cross-sectional view showing a process of manufacturing the multi-layered film according to the embodiment of the invention.
FIG. 2C is a cross-sectional view showing a process of manufacturing the multi-layered film according to the embodiment of the invention.
FIG. 3 is a view schematically showing an internal constitution of a film formation apparatus used in the embodiment of the invention.
Fig. 4 is a chart showing the diffraction peaks which indicate the crystal structure of the PZT film formed by Sample 1.
FIG. 5 is a chart showing the diffraction peaks which indicate the crystal structure of the PZT film formed by Sample 2.
FIG. 6 is a chart showing relationship between the film deposition temperature (substrate temperature) of a PZT film and the peak intensities of the pyrochlore phase of the obtained PZT film.
FIG. 7 is a chart showing the crystallinity of the PZT film of Sample 1.
FIG. 8 is a photograph of a top surface of a PZT film of Sample 4.
FIG. 9 is a photograph of a top surface of a PZT film of Sample 5.
FIG. 10 is a photograph of a top surface of a PZT thin film of Sample 6.
FIG. 11 is a graph showing the piezoelectricity of the PZT films of Samples 4 to 6.
FIG. 12 is a chart showing the withstand voltages of the PZT films of Samples 4 to 6.
FIG. 13 is a chart showing relationship between withstand voltage characteristics and Pb-contents of a PZT film.
FIG. 14 is a chart showing relationship between withstand voltage characteristics and Pb-contents of a PZT film.
FIG. 15 is a photograph of a top surface of a PZT film.
FIG. 16 is a photograph of a top surface of a PZT film.
FIG. 17 is a photograph of a top surface of a PZT thin film.

### EMBODIMENTS FOR CARRYING OUT THE INVENTION

Hereinafter, an embodiment of a method of manufacturing a multi-layered film and a multi-layered film according to the invention will be described with reference to drawings.

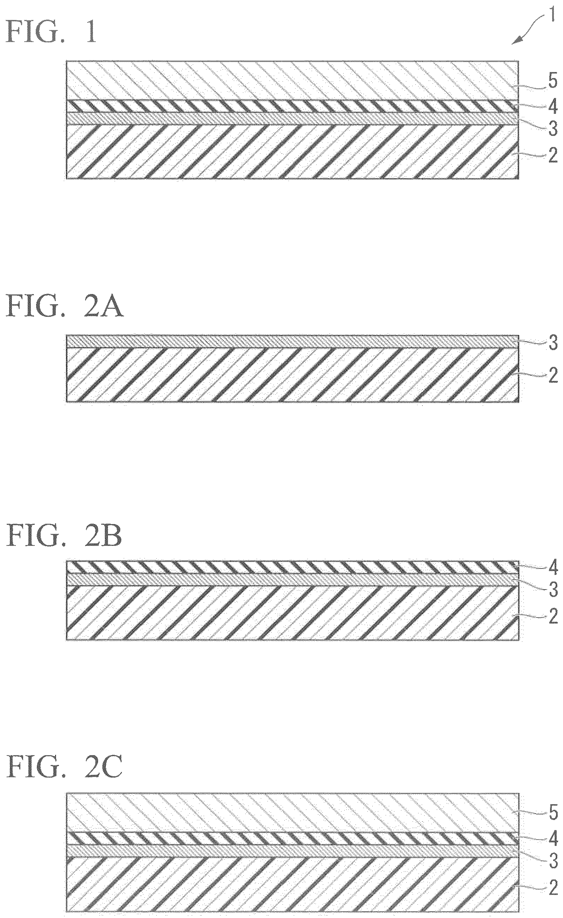

FIG. 1 is a cross-sectional view showing one configuration example of a multi-layered film according to the embodiment.

In the multi-layered film 1, at least, an electroconductive layer 3 made of platinum (Pt), a seed layer 4 including lanthanum (La), nickel (Ni), and oxygen (O), and a dielectric layer 5 are sequentially arranged on a main surface side (on a first surface) of a substrate 2 made of silicon.

The dielectric layer 5 is not particularly limited, but is made of a ferroelectric material such as lead zirconate titanate Pb(ZrₓTi₁₋ₓ)O₃: PZT, PbTiO₃, BaTiO₃, PMM-PZT, PNN-PZT, PMN-PZT, PNN-PT, PLZT, PZTN, NBT, KNN, or the like.

The dielectric layer 5 is disposed on the seed layer 4 including lanthanum (La), nickel (Ni), and oxygen (O).

Since the seed layer 4 has, for example, a perovskite structure, the dielectric layer 5 to be disposed on the seed layer 4 is formed so as to have a perovskite structure which does not include a different phase.

Accordingly, the multi-layered film 1 has excellent characteristics such as a high piezoelectricity and a high withstand voltage.

The foregoing multi-layered film 1 is preferably used in, for example, a piezo element or the like.

The multi-layered film 1 is formed by the manufacturing method which is described below.

FIGS. 2A to 2C are cross-sectional views showing processes of manufacturing the multi-layered film according to the embodiment of the invention.

The method of manufacturing a multi-layered film according to the embodiment of the invention at least includes: a step A of forming the electroconductive layer 3 on the substrate 2 (FIG. 2A); a step B of forming the seed layer 4 so as to coat the electroconductive layer 3 (FIG. 2B); and a step C of forming the dielectric layer 5 so as to coat the seed layer 4 (FIG. 2C).

In the foregoing step B of the method of manufacturing the multi-layered film 1, an oxidative product having a perovskite structure is formed as the seed layer 4 by a sputtering method.

Since the oxidative product having a perovskite structure is formed as the seed layer 4 by the sputtering method in the step B, it is possible to form a film at a lower temperature when the dielectric layer 5 is formed on the seed layer 4.

Furthermore, as a result of forming the dielectric layer 5 on the seed layer 4 having the perovskite structure, the dielectric layer 5 is formed so as to have a perovskite structure which does not include a different phase such as a pyrochlore phase.

The resultant multi-layered film 1 has excellent characteristics such as a high piezoelectricity and a high withstand voltage.

For this reason, according to the embodiment of the invention, it is possible to provide the method of manufacturing a multi-layered film which has a wider temperature margin.

In the following explanation, as an example, the case will be described where lead zirconate titanate lead zirconate titanate (Pb(Zr,Ti)O₃: PZT) is used as the dielectric layer 5; however, the invention is not limited to this.

### (Film Formation Apparatus)

Hereinbelow, the configuration of a preferred film formation apparatus in order to carry out the method of manufacturing a multi-layered film according to the embodiment of the invention will be described.

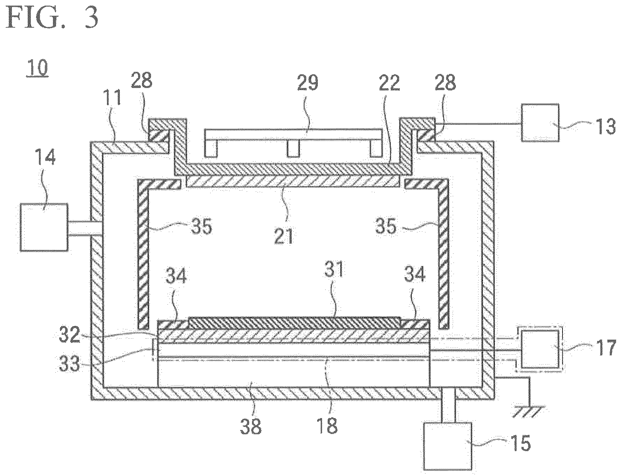

FIG. 3 is a schematic cross-sectional view showing an example of the internal constitution of a film formation apparatus 10.

The film formation apparatus 10 includes: a vacuum chamber 11; a target 21 disposed inside the vacuum chamber 11; a substrate holding table 32 that is disposed at the position opposed to the target 21 and holds a substrate 31 (substrate 2); a temperature controller 18 that adjusts a substrate temperature by heating or cooling down the substrate 31 held by the substrate holding table 32; a sputtering power source 13 that applies a voltage to the target 21; a sputtering gas introduction unit 14 that introduces a sputtering gas into the inside of the vacuum chamber 11; a vacuum pump 15 that reduces the pressure inside the vacuum chamber 11 by discharging the gas inside the vacuum chamber 11 to the outside; and a first adhesion-preventing plate 34 and a second adhesion-preventing plate 35 which are provided in the vacuum chamber 11 at the positions to which the particles discharged from the target 21 are adhered.

A cathode electrode 22 is disposed at the upper wall surface of the vacuum chamber 11 with an insulating member 28 interposed therebetween, and the cathode electrode 22 is electrically insulated from the vacuum chamber 11.

The vacuum chamber 11 has a ground potential.

One surface side (first electrode surface) of the cathode electrode 22 is locally exposed to the inside of the vacuum chamber 11.

The target 21 is fixed in close contact with the center portion of the exposed region of one surface side of the cathode electrode 22.

The target 21 is electrically connected to the cathode electrode 22.

The sputtering power source 13 is disposed outside the vacuum chamber 11, electrically connected to the cathode electrode 22, and can apply an alternating voltage to the target 21 through the cathode electrode 22.

A magnet unit 29 is disposed on the opposite side of the surface of the cathode electrode 22 on which the target 21 is disposed, that is, on the other surface side of the cathode electrode 22 (second electrode surface).

The magnet unit 29 is configured to form magnetic lines of force on the surface of the target 21.

The support 32 (substrate holding table) on which the substrate 31 is to be mounted is made of, for example, carburization silicon (SiC), the outer-periphery of the support 32 is formed larger than the outer-periphery of the substrate 31, and the surface of the support 32 is arranged so as to face the surface of the target 21.

A device (electrostatic attraction unit) which electrostatically attracts the substrate 31 is located inside the support 32.

When the substrate 31 is electrostatically attracted to the center region of the surface of the support 32, the back surface of the substrate 31 is brought into close contact with the center region of the surface of the support 32, and the substrate 31 is thermally connected to the support 32.

The first adhesion-preventing plate 34 is formed of quartz or ceramics such as alumina.

The inner-periphery of the first adhesion-preventing plate 34 is larger than the outer-periphery of the substrate 31, and the first adhesion-preventing plate 34 is formed in an annular shape.

The first adhesion-preventing plate 34 is arranged so as to cover the outer-edge portion which is the outside of the center region of the surface of the support 32.

Consequently, the particles discharged from the target 21 are prevented from being adhered to the outer-edge portion of the surface of the support 32.

The back surface of the first adhesion-preventing plate 34 is brought into close contact with the outer-edge portion of the surface of the support 32, and the first adhesion-preventing plate 34 is thermally connected to the support 32.

When the substrate 31 is mounted on the center region of the surface of the support 32, the first adhesion-preventing plate 34 is arranged so as to surround the outer side of the outer-periphery of the substrate 31.

The second adhesion-preventing plate 35 is formed of quartz or ceramics such as alumina.

The inner-periphery of the second adhesion-preventing plate 35 is larger than the outer-periphery of the target 21 or the outer-periphery of the substrate 31, and the second adhesion-preventing plate 35 is formed in a cylindrical shape.

The second adhesion-preventing plate 35 is arranged between the support 32 and the cathode electrode 22 and is configured to surround the side region of the space between the substrate 31 and the target 21.

For this reason, the particles discharged from the target 21 are prevented from being adhered to the wall surface of the vacuum chamber 11.

The temperature controller 18 includes a heat generation member 33 and a heating power source 17.

As a material used to form the heat generation member 33, SiC is used.

The heat generation member 33 is placed at the position on the opposite side of the surface of the support 32 on which the substrate 31 is to be disposed.

The heating power source 17 is electrically connected to the heat generation member 33.

When a direct current is supplied to the heat generation member 33 from the heating power source 17, the heat generated from the heat generation member 33 is transmitted through the support 32 to the substrate 31 mounted on the support 32 and the first adhesion-preventing plate 34, and the substrate 31 and the first adhesion-preventing plate 34 are thereby heated together.

The back surface of the substrate 31 is in close contact with the center region of the surface of the support 32, the heat is uniformly transferred to the center portion of the substrate 31 and the outer-edge portion.

A cooling unit 38 is disposed on the opposite side of the surface of the heat generation member 33 on which the support 32 is disposed.

The cooling unit 38 is configured to be able to circulate a temperature-controlled cooling medium in the internal side thereof and prevents the wall surface of the vacuum chamber 11 from being heated even where heat is generated from the heat generation member 33.

The sputtering gas introduction unit 14 is connected to the inside of the vacuum chamber 11 and is configured to be able to introduce a sputtering gas into the inside of the vacuum chamber 11.

### (Method of Forming Multi-layered Film)

Hereinbelow, a method of forming a multi-layered film will be described.

FIG. 3 is a view schematically showing an internal constitution of a film formation apparatus used to manufacture a multi-layered film.

FIGS. 2A to 2C are cross-sectional views showing processes of manufacturing the multi-layered film according to the embodiment of the invention.

FIG. 3 shows an example of the case where the film formation apparatus 10 includes one vacuum chamber 11 in order to simplify the explanation thereof; however, a multi-layered film is manufactured by use of at least three vacuum chambers 11a, 11b, and 11c (11) in the steps A to C of the manufacturing method which will be described below.

Particularly, in the explanation of the film formation apparatus 10 that includes three vacuum chambers with reference to FIG. 3, three vacuum chambers are aligned in the depth direction of the paper face of FIG. 3.

In the three vacuum chambers 11a, 11b, and 11c, an isolation valve which is not shown in the figure is disposed between the vacuum chambers 11a and 11b, and an isolation valve which is not shown in the figure is also disposed between the vacuum chambers 11b and 11c.

Each of the vacuum chambers 11a, 11b, and 11c can generate an independent vacuum atmosphere by closing the isolation valves.

Furthermore, two vacuum chambers adjacent to each other are communicated with each other by opening the isolation valve, and it is possible to transfer a substrate in the direction from one of vacuum chamber of the two vacuum chambers to the other of the vacuum chambers.

In the film formation apparatus 10 including the above-described three vacuum chambers, for example, the step A is carried out in the vacuum chamber 11a, the step B is carried out in the vacuum chamber 11b, and the step C is carried out in the vacuum chamber 11c.

Particularly, the vacuum chamber 11a (11) is used to form an electroconductive layer, the vacuum chamber 11b (11) is used to form a seed layer, and the vacuum chamber 11c (11) is used to form a dielectric layer.

In the following explanation, a method of forming a multi-layered film will described using the reference numerals 11a, 11b, and 11c (11) representing the vacuum chambers.

Identical reference numerals are used for the three vacuum chambers which are identical to those of the members constituting the vacuum chamber (refer to FIG. 3).

### (Step A): Formation of Electroconductive Layer

As shown in FIG. 2A, the electroconductive layer 3 made of platinum (Pt) is formed on a main surface side of the substrate 2 made of silicon (Si).

Hereinbelow, the case of directly forming an electroconductive layer on the main surface side of the substrate will be described; however, if required, before forming the electroconductive layer, the other film may be provided on the main surface side of the substrate 2.

As the target 21 a (21), a target made of Pt is disposed in the vacuum chamber 11a (11).

By reducing the pressure of the internal space of the vacuum chamber 11a (11) by use of the vacuum pump 15, the internal space of the vacuum chamber 11a (11) becomes a vacuum atmosphere having a high degree of vacuum.

The degree of vacuum in this vacuum atmosphere is higher than the degree of vacuum of the atmospheric pressure in which a film is formed.

After that, vacuum in the atmosphere in the vacuum chamber 11a (11) is continuously maintained by driving the vacuum pump 15.

While maintaining the vacuum atmosphere in the vacuum chamber 11, the substrate 31 on which a film is to be formed in the internal space of the vacuum chamber 11a (11) is transferred to the inside of the vacuum chamber 11 through an inlet which is not shown in the figure.

Subsequently, the substrate 31 is held on the center region of the support 32 so that the main surface side of the substrate 31 faces the sputtering surface of the target 21.

The temperature-controlled cooling medium circulates in the coolling unit 38 in advance.

Next, in a step of forming an electroconductive layer, while the substrate 31 is maintained in a film deposition temperature, an Ar gas serving as a sputtering gas is introduced into the inside of the vacuum chamber 11 from the sputtering gas introduction unit 14, an alternating voltage is applied from the power source 13 to the cathode electrode 22, and Pt target is thereby sputtered.

Consequently, the Pt electroconductive layer 3 is formed on the main surface side of the substrate 31.

### (Step B): Formation of Seed Layer

As shown in FIG. 2B, the seed layer 4 is formed so as to coat the electroconductive layer 3.

In the step B, as the seed layer 4, an oxidative product having a perovskite structure is formed by the sputtering method.

The seed layer 4 is not particularly limited; however, for example, a Pb(ZrₓTi₁₋ₓ)O₃ film, an SrRuO₃ film, a PbTiO₃ film, a PbLaTiO₃ film, a LaNiO₃ film, or the like is adopted thereto.

As a result of using the oxidative product having the perovskite structure as the seed layer 4, it is possible to form PZT having a perovskite structure when the dielectric layer 5 is formed on the seed layer 4.

Among them, particularly, LaNiO₃ (LNO) is preferable.

LNO has a high degree of self-compatibility on the (002) face and can be film-formed at a low-temperature such as 300°C.

Moreover, LNO has a low resistance.

As a result of using LNO as the seed layer 4, generation of a pyrochlore phase which is a different phase can be reduced when the dielectric layer 5 is formed, it is possible to form the PZT having a perovskite structure in a wide temperature margin including a lower temperature region.

That is, in the step B, the oxidative product including lanthanum (La), nickel (Ni), and oxygen (O) is formed as the seed layer 4.

As the target 21, an LNO target made of an oxidative product including La, Ni, and O is disposed in the vacuum chamber 11b (11).

By reducing the pressure of the internal space of the vacuum chamber 11b (11) by use of the vacuum pump 15 in advance, the internal space of the vacuum chamber 11b (11) becomes a vacuum atmosphere having a high degree of vacuum.

The degree of vacuum in this vacuum atmosphere is higher than the degree of vacuum of the atmospheric pressure in which a film is formed.

After that, vacuum in the atmosphere in the vacuum chamber 11b (11) is continuously maintained by driving the vacuum pump 15.

While maintaining the vacuum atmosphere in the vacuum chamber 11b (11), the substrate 31 on which the Pt electroconductive layer 3 is provided in advance is transferred from the vacuum chamber 11a (11) to the internal space of the vacuum chamber 11b (11).

Subsequently, the substrate 31 is held on the center region of the surface of the support 32 so that the main surface side of the substrate 31, that is, the Pt electroconductive layer 3 faces the sputtering surface of the LNO target 21.

Next, the substrate 31 is maintained in a film deposition temperature, an Ar gas and an oxygen gas which serve as a sputtering gas are introduced from the sputtering gas introduction unit 14 to the vacuum chamber 11b (11), an alternating voltage is applied from the power source 13 to the cathode electrode 22, and the LNO target is thereby sputtered.

Consequently, the seed layer 4 made of LNO is formed on the Pt electroconductive layer 3 located on the main surface side of the substrate 31.

Particularly, in the case of forming the seed layer 4, the substrate temperature in the film formation time is controlled based on a predetermined temperature profile as necessary.

The temperature may be constantly maintained from start of film formation to completion of film formation and the temperature may be set so that, for example, the temperature in the start of the film formation is higher than the temperature in the completion of the film formation.

### (Step C): Formation of Dielectric Layer

As shown in FIG. 2C, the dielectric layer 5 is formed so as to coat the seed layer 4.

In the step C, as the dielectric layer 5, a PZT film is formed by the sputtering method.

As the target 21, a PZT target is disposed in the vacuum chamber 11c (11).

By reducing the pressure of the internal space of the vacuum chamber 11c (11) by use of the vacuum pump 15, the internal space of the vacuum chamber 11c (11) becomes a vacuum atmosphere having a high degree of vacuum.

The degree of vacuum in this vacuum atmosphere is higher than the degree of vacuum of the atmospheric pressure in which a film is formed.

After that, vacuum in the atmosphere in the vacuum chamber 11c (11) is continuously maintained by driving the vacuum pump 15.

While maintaining the vacuum atmosphere in the vacuum chamber 11c (11), the substrate 31 on which the Pt electroconductive layer 3 and the seed layer 4 are provided in advance is transferred from the vacuum chamber 11b (11) to the internal space of the vacuum chamber 11 c (11).

Subsequently, the substrate 31 is held on the center region of the surface of the support 32 so that the main surface side of the substrate 31, that is, the seed layer 4 faces the sputtering surface of the PZT target 21.

Next, the substrate 31 is maintained in a film deposition temperature, an Ar gas and an oxygen gas which serve as a sputtering gas are introduced from the sputtering gas introduction unit 14 to the vacuum chamber 11b (11), an alternating voltage is applied from the power source 13 to the cathode electrode 22, and the PZT target is thereby sputtered.

Accordingly, the dielectric layer 5 formed of the PZT film having the perovskite structure is formed on the seed layer 4 located on the main surface side of the substrate 31.

Particularly, in the case of forming the dielectric layer 5, the substrate temperature in the film formation time is controlled based on a predetermined temperature profile as necessary.

The temperature may be constantly maintained from start of film formation to completion of film formation and the temperature may be set so that, for example, the temperature in the start of the film formation is higher than the temperature in the completion of the film formation.

As described later, as compared with the layered structure in which a conventional seed layer is not provided (electroconductive layer / dielectric layer), it is possible to widen the range (band) of a film deposition temperature at which a pyrochlore phase can be prevented from being formed by providing an SRO film (SrRuO) or an LNO film as the seed layer 4.

That is, according to the embodiment of the invention, it is possible to widen the temperature margin.

In particular, as a result of adopting the seed layer 4 formed of the LNO film, it is possible to extend the range (band) of the film deposition temperature, at which a pyrochlore phase can be prevented from being formed, to be a lower temperature side, and the lowering of the temperature in a high-volume production process is thereby realized.

After the PZT thin film having a predetermined film thickness is formed on the substrate 31, the application of voltage from the power source 13 to the cathode electrode 22 is stopped, and the introduction of the sputtering gas from the sputtering gas introduction unit 14 to the vacuum chamber 11c (11) is stopped.

The supply of the electrical current from the heating power source 17 to the heat generation member 33 is stopped, the heat generation member 33 is cooled down, the temperature of the substrate 31 becomes lower than the film deposition temperature.

For example, in the vacuum chamber 11c (11), the temperature of the heat generation member 33 is reduced to be lower than or equal to 400°C, and the temperature is maintained.

While maintaining the vacuum atmosphere in the vacuum chamber 11, the film-formed substrate 31 on which the multi-layered film is formed by stacking the three layers (the electroconductive layer, the seed layer, and the dielectric layer) in order is discharged to the outside of the vacuum chamber 11 through an outlet which is not shown in the figure.

Particularly, a transfer robot which is not shown in the figure is preferably used to transfer the aforementioned substrate, that is, transfer the substrate from the outside to the vacuum chamber 11a (11), transfer the substrate between the vacuum chambers, transfer the substrate from the vacuum chamber 11c (11) to the outside.

In the above manner, the multi-layered film 1 having the structure shown in FIG. 1 is manufactured.

In the multi-layered film 1, since the seed layer 4 has, for example, a perovskite structure, the dielectric layer 5 has a perovskite structure in which a different phase is absent.

Accordingly, the multi-layered film 1 can realize excellent characteristics satisfying both of, for example, a high piezoelectricity and a high withstand voltage.

The foregoing multi-layered film 1 is preferably used in, for example, a piezo element or the like.

### Experimental Example

Hereinbelow, examples of experiment will be described which are carried out in order to check the effect obtained by the above-described embodiment of the invention.

The conditions of the seed layer are varied, the PZT films (dielectric layer) are formed, and the characteristics thereof are evaluated.

### (Experimental Example 1)

In this example, a multi-layered film was formed by stacking an electroconductive layer formed of a Pt film, a seed layer formed of an LaNiO₃ film, and a dielectric layer formed of a PZT film in order.

As the substrate, a silicon (Si) wafer having a diameter of eight inches was used.

Here, a substrate was used which has a main surface side of the Si wafer on which a thermal oxidation film (SiO₂ film), a Ti film functioning as an adhesion layer (thickness of 20 nm), and a Pt film functioning as a lower electrode layer (thickness of 100 nm) are layered in order in advance.

As a sputtering apparatus, a flat-plate magnetron sputtering apparatus (SME-200) having the configuration shown in FIG. 3 was used.

As a sputtering power source, a high-frequency power source (frequency of 13.56 MHz) was used.

The conditions of forming the seed layer formed of the LaNiO₃ film were determined as follows.

As a target, an LaNiO₃ target having a diameter of 300 mm and a thickness of 5 mm was used.

The sputtering power was 1.0 (kW), the inside pressure of the vacuum chamber during sputtering was 0.4 (Pa), and the substrate temperature was 250 to 400°C.

The film thickness of the seed layer was 40 to 300 (nm).

The conditions of forming the dielectric layer formed of the PZT film were determined as follows.

As a target, a PZT target having a diameter of 300 mm and a thickness of 5 mm was used.

The sputtering power was 2.5 (kW), the inside pressure of the vacuum chamber during sputtering was 0.5 (Pa), and the substrate temperature was 445 to 700°C.

The film thickness of the dielectric layer was 2.0 (*µ*m).

The sample of the experimental example 1 which is manufactured under the aforementioned conditions was referred to as Sample 1.

### (Experimental Example 2)

In this example, a multi-layered film was formed in a way similar to the case of the experimental example 1 with the exception that the seed layer is varied from the LaNiO₃ film to an SrRuO₃ film.

The conditions of forming the seed layer formed of the SrRuO₃ film were determined as follows.

As a target, an SrRuO₃ target having a diameter of 300 mm and a thickness of 5 mm was used.

The sputtering power was 0.7 (kW), the inside pressure of the vacuum chamber during sputtering was 0.4 (Pa), and the substrate temperature was 500 to 800°C.

The film thickness of the seed layer was 40 to 300 (nm).

The sample of the experimental example 2 which is manufactured under the aforementioned conditions was referred to as Sample 2.

### (Experimental Example 3)

In this example, a multi-layered film was formed by forming a PZT film on a Pt thin film on a substrate without providing the seed layer.

The conditions of forming the dielectric layer formed of the PZT film were the same as that of the experimental example 1.

The sample of the experimental example 3 which is manufactured under the aforementioned conditions was referred to as Sample 3.

Regarding the PZT films of Samples 1 to 3 manufactured in the experimental examples 1 to 3, the crystal structures of the PZT films were analyzed by use of an X-ray diffraction method.

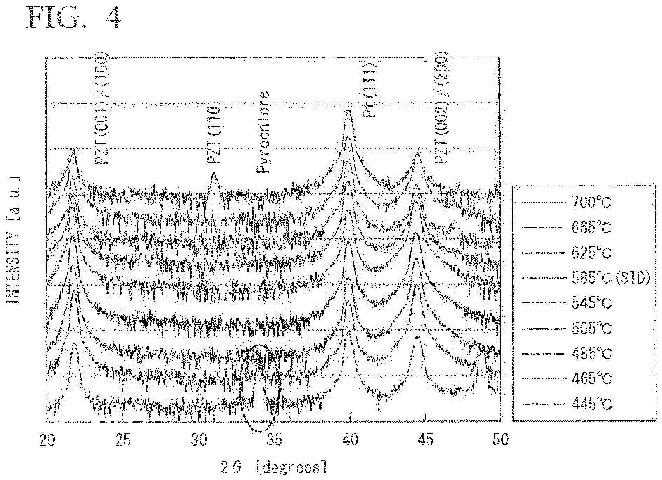

FIG. 4 is an X-ray chart showing Sample 1 (seed layer: LaNiO₃ film).

In Sample 1, the substrate temperature when the film is formed was varied in the range of 445 to 700°C, the formation of the PZT film was carried out, and the crystal structure of the PZT film which is formed at each substrate temperature was analyzed.

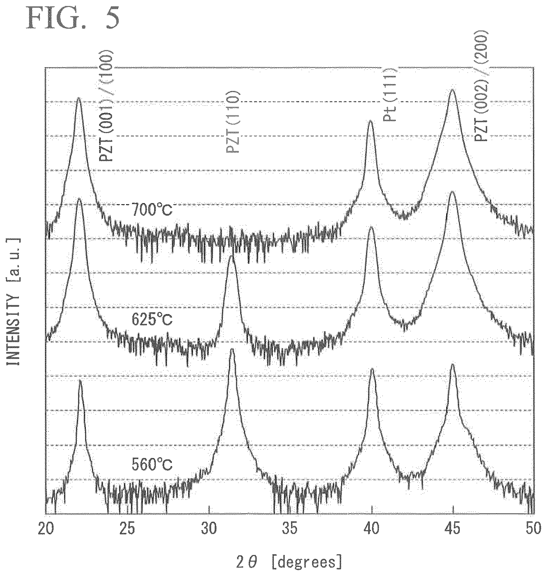

FIG. 5 is an X-ray chart showing Sample 2 (seed layer: SrRuO₃ film).

In Sample 1, the substrate temperature when the film is formed was varied in the range of 560 to 700°C, the formation of the PZT film was carried out, and the crystal structure of the PZT film which is formed at each substrate temperature was analyzed.

From FIG. 4, in Sample 1 in which the seed layer formed of the LaNiO₃ film is formed, in the case where the substrate temperature is only 445°C, it was determined that the PZT film has a pyrochlore phase which is a different phase.

In the case where the other substrate temperature (465 to 700°C), it was determined that a pyrochlore phase is absent.

Particularly, as a result of adopting the configuration using the LaNiO₃ film as the seed layer, it is apparent that the PZT film is obtained which does not include a pyrochlore phase in the wider substrate temperature range (235°C).

Similarly, from FIG. 5, in Sample 2 in which the seed layer formed of the SrRuO₃ film is formed, in the case where the film deposition temperature is 560 to 700°C, it was not determined that the PZT film has a pyrochlore phase which is a different phase.

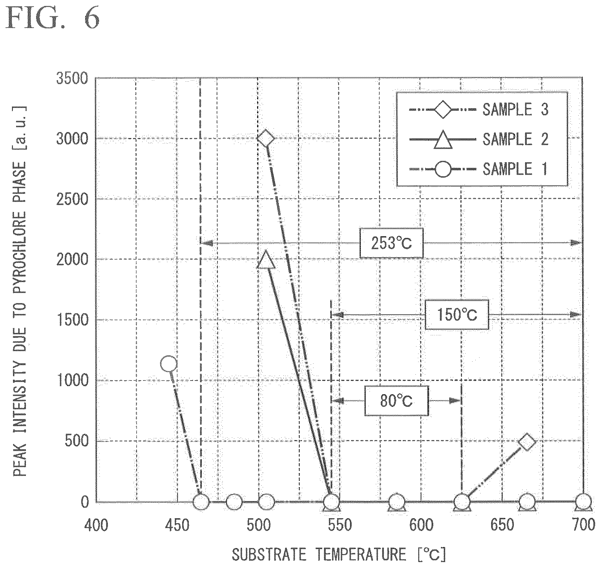

Regarding the PZT films which are manufactured under various substrate temperatures at when a film is formed, FIG. 6 is a chart showing relationship between the substrate temperature and the peak intensities of the pyrochlore phase.

In FIG. 6, the mark "O" represents the case of Sample 1 (seed layer: LaNiO₃ film).

The mark "Δ" represents the case of Sample 2 (seed layer: SrRuO₃ film).

The mark "◇" represents the case of Sample 3 (seed layer: absence).

The following points were apparent from FIG. 6.
(A1) In Sample 3 in which the PZT film is formed without forming the seed layer, in the temperature range of approximately 80°C, 545 to 625°C, the peak of the pyrochlore phase is not observed (that is, it is possible to prevent a pyrochlore phase which is a different phase from being formed).
(A2) In Sample 1 in which the PZT film is formed on the seed layer formed of the LaNiO₃ film, in the temperature range of approximately 235°C, 465 to 700°C, and in the temperature range extremely wider than that of Sample 3, the peak of the pyrochlore phase is not observed.

That is, the temperature range in which the peak of the pyrochlore phase is not observed (the temperature range in which the pyrochlore phase can be prevented from being formed) becomes broader so as to be at the high temperature region (a temperature range higher than 625°C) and the low-temperature region (a temperature range lower than 545°C).
(A3) Also, similar to Sample 1, in Sample 2 in which the PZT film is formed on the seed layer formed of the SrRuO₃ film, the temperature range in which the peak of the pyrochlore phase is not observed (the temperature range in which the pyrochlore phase can be prevented from being formed) becomes broader so as to be at the high temperature region (a temperature range higher than 625°C), but it is not observed that the temperature range does not become broader so as to be at the low-temperature region (a temperature range lower than 545°C).

From the above results, by forming the PZT film on the seed layer formed of the LaNiO₃ film or the SrRuO₃ film, since the temperature range in which the pyrochlore phase can be prevented from being formed becomes broader, an increase in the margin to form a film is realized.

Particularly, since the seed layer formed of the LaNiO₃ film causes the temperature range in which the pyrochlore phase can be prevented from being formed to be broader so as to be at the low-temperature region (an increase in the temperature margin is realized), it contributes to the lowering of the temperature in the manufacturing process.

A pyrochlore phase which is a different phase is not observed at the time when an interface of the PZT film formed on the seed layer formed of the LaNiO₃ film is initially formed.

The reason is believed to be that, since LaNiO₃ has the coefficient of thermal expansion larger than that of PZT, the PZT film receives a compressive stress in the cooling process, and a BZT film is thereby oriented in the c-axis.

Accordingly, it was determined that, as a result of using the LaNiO₃ film as the seed layer, in a wider temperature range including a low-temperature region, for example, 465°C (substrate temperature), it is possible to form the PZT film having a perovskite structure in which a pyrochlore phase which is a different phase is absent.

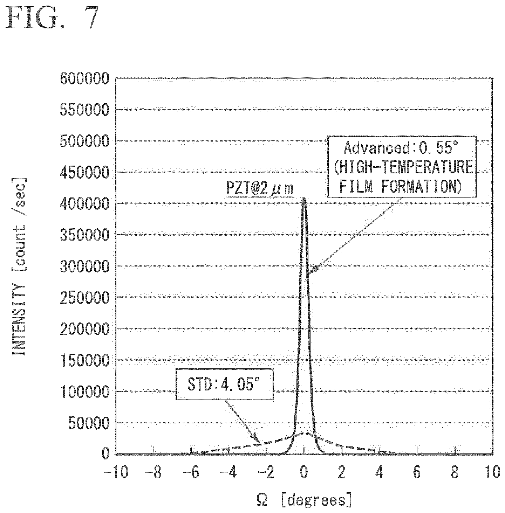

FIG. 7 is an X-ray chart showing the crystallinity of the PZT films of Sample 1 (a solid line) and Sample 3 (a dotted line).

It was determined that, a poly PZT is used in the Sample 1; however, a half-value width of a (100) rocking curve is 0.55 degrees, and it has the crystallinity extremely higher than that of Sample 3 (half-value width of 4.05 degrees).

Hereinbelow, the evaluation results of the piezoelectricity and the withstand voltage of the PZT film will be described.

In order to carry out such evaluation, three Samples 4 to 6 which will be described later were manufactured.

The experiments were carried out.

### (Experimental Example 4)

A seed layer formed of an LaNiO₃ film was formed on a substrate, and a PZT film (dielectric layer) was formed on the seed layer at 585°C.

The conditions of forming the seed layer and the conditions of forming a film other than the PZT film are the same as that of the aforementioned Sample 1.

The sample of the experimental example 4 which is manufactured under the aforementioned conditions was referred to as Sample 4.

### (Experimental Example 5)

A PZT film was formed on a Pt thin film of a Si substrate without forming a seed layer at a substrate temperature of 585°C.

The conditions of forming a film other than the PZT film are the same as that of the aforementioned Sample 1.

The sample of the experimental example 5 which is manufactured under the aforementioned conditions was referred to as Sample 5.

### (Experimental Example 6)

A PZT film was formed on a Pt thin film of a Si substrate without forming a seed layer at a substrate temperature of 585°C, thereafter annealing treatment was carried out under the conditions of "700°C, for 15 minutes".

The conditions of forming a film other than the PZT film are the same as that of the aforementioned Sample 1.

Regarding the PZT films of Samples 4 to 6 manufactured in the experimental examples 4 to 6, the surface profile and the sectional profile were examined by use of a secondary electron microscope (SEM).

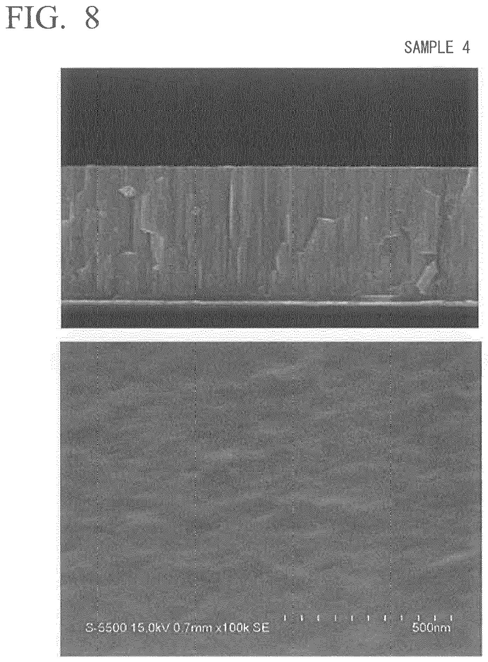

FIGS. 8 to 10 are the SEM photographs of Samples 4 to 6, respectively, the photographs which are located at the upper positions of FIGS. 8 to 10 shows cross-sectional surfaces of the PZT films, and the photographs which are located at the lower positions of FIGS. 8 to 10 shows top surfaces of the PZT films.

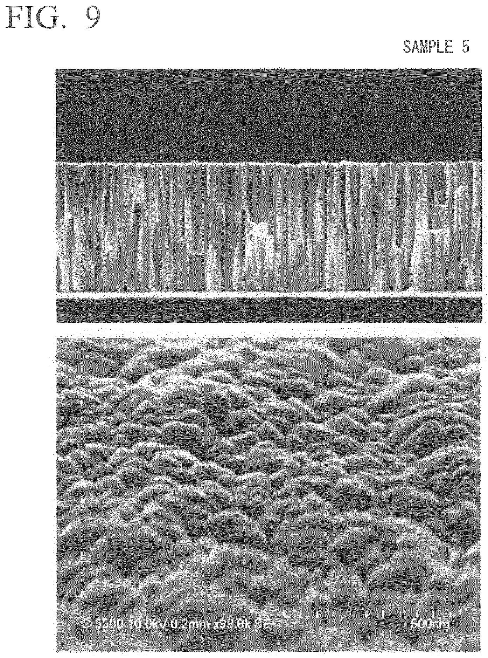

The following points were apparent from the SEM photographs.
(B1) From FIG. 8, the top surface of the PZT film of Sample 4 is extremely smooth, and a pillar-shaped structure is not so remarkably observed in the cross-sectional surface thereof.
(B2) From FIG. 9, as compared with Sample 4, the shapes of individual crystalline grains remain on the top surface of the PZT film of Sample 5, and a surface roughness is significantly observed.

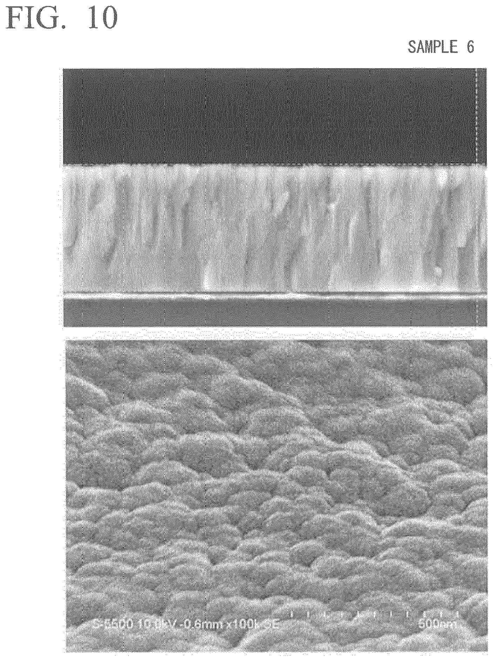

It is apparent from the cross-sectional photographs that a sharp pillar-shaped configuration is formed.
(B3) From FIG. 10, unlike the PZT film of Sample 5, the shapes of individual crystalline grains remain on the top surface of the PZT film of Sample 6, and a surface roughness is significantly observed.

However, a pillar-shaped structure is not remarkably observed in the cross-sectional surface.

The SEM used in the aforementioned evaluation has a length measuring function, and the surface roughness of the PZT film RMS (nm) of each of Samples was determined

Additionally, the density of the PZT film of each Sample was determined according to the difference between the weight before dissolving the PZT film and the weight after the PZT film was completely dissolved by use of acid.

Table 2 shows the surface roughness (RMS) and the density of the PZT films shown in FIGS. 8 to 10.

**(Table 2)**

| PZT FILM | FIG. 8 | FIG. 9 | FIG. 10 |
|---|---|---|---|
| SURFACE ROUGHNESS RMS [nm] | 6.4 | 10.2 | 6.3 |
| DENSITY [%] | 96.0 | 90.7 | 93.9 |

It is determined from Table 2 that, the LaNiO₃ film is used as the seed layer, the PZT film of Sample 4 which is obtained by forming at a low-temperature is higher in density than the PZT films of Samples 5 and 6 which are formed at a high temperature.

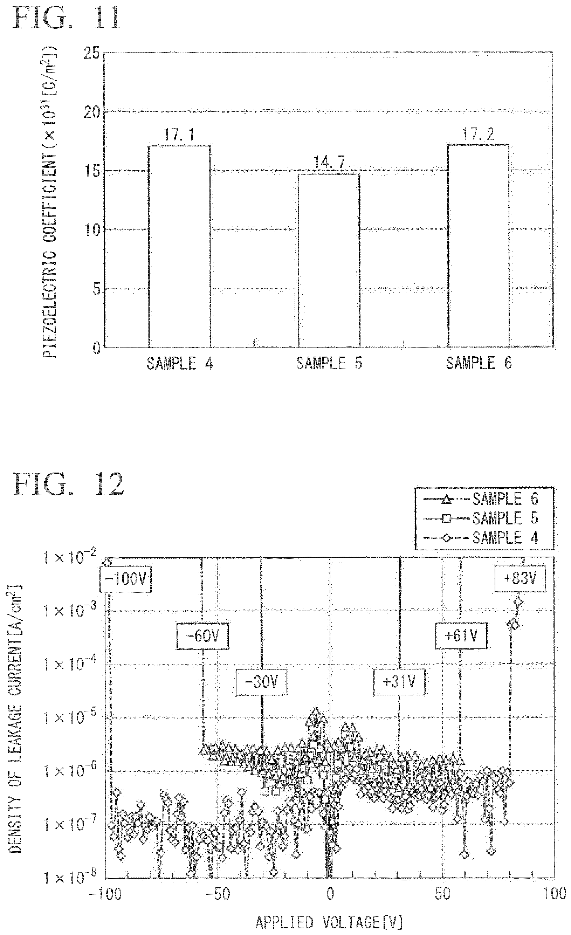

FIG. 11 is a graph showing the evaluation results of the piezoelectricity (piezoelectric coefficient) of the PZT films of Samples 4 to 6 which are manufactured in the experimental examples 4 to 6.

FIG. 12 is a graph showing the evaluation results of the withstand voltage (density of leakage current) of the PZT films of Samples 4 to 6 which are manufactured in the experimental examples 4 to 6.

The following points were apparent from FIGS. 11 and 12.
(C1) From FIG. 11, both Sample 4 (17.1) and Sample 6 (17.2) are substantially equally high in piezoelectric coefficient, and Sample 5 (14.7) is lower than those of the Samples.
(C2) From FIG. 12, the range of the applied voltage of Sample 5 (-30V, +31V), in which a stable state can be maintained without a rapid increase in density of leakage current, is narrowest.

The range (-60V, +61 V) of Sample 6 becomes wide to be twice that of Sample 5.

Moreover, the range (-100V, +83V) of Sample 4 further becomes wide such that the range becomes wide to be three or more times that of Sample 5.

From the above results, by use of the method of manufacturing a multi-layered film according to the embodiment of the invention, it was determined that the multi-layered film having both excellent piezoelectricity and an extremely high withstand voltage is obtained.

Particularly, it was determined that, as a result of using the LaNiO₃ film as the seed layer, a highly-densified PZT film having a perovskite structure without a different phase can be formed in a wide temperature region including a low-temperature region.

Consequently, it is apparent that the PZT film which is manufactured at low-temperature region has both excellent piezoelectricity and withstand voltage.

As described above, the method of manufacturing a multi-layered film and the multi-layered film according to the embodiment of the invention are described, the invention is not limited to this, and various modifications may be made insofar as they do not depart from the scope of the invention.

### Industrial Applicability

The invention is widely applicable to a method of manufacturing a multi-layered film, and a multi-layered film.

### DESCRIPTION OF REFERENCE NUMERAL

1 multi-layered film, 2 substrate, 3 electroconductive layer, 4 seed layer, 5 dielectric layer, 10 film formation apparatus, 11 vacuum chamber, 13 sputtering power source, 14 sputtering gas introduction unit, 18 temperature controller, 19 heater of adhesion-preventing plate, 21 target, 31 substrate, 32 support, 34 adhesion-preventing plate (first adhesion-preventing plate).

## Claims

1. A method of manufacturing a multi-layered film, comprising:
forming an electroconductive layer on a substrate;
forming a seed layer including an oxidative product having a perovskite structure so as to coat the electroconductive layer by a sputtering method; and
forming a dielectric layer so as to coat the seed layer.

2. The method of manufacturing a multi-layered film according to claim 1, wherein
when the seed layer is formed, the seed layer is formed so that the oxidative product includes lanthanum (La), nickel (Ni), and oxygen (O).

3. The method of manufacturing a multi-layered film according to claim 2, wherein
when the dielectric layer is formed, a relational expression of Td ≤ 500°C is satisfied where a substrate temperature is defined as Td (dielectric) when the dielectric layer is formed.

4. The method of manufacturing a multi-layered film according to claim 3, wherein
when the seed layer is formed, a relational expression of Ts<Td is satisfied where a substrate temperature is defined as Ts (seed).

5. A multi-layered film formed by use of the method of manufacturing a multi-layered film according to any one of claims 1 to 4, in which an electroconductive layer made of platinum (Pt), a seed layer including lanthanum (La), nickel (Ni), an oxygen (O), and a dielectric layer are at least arranged in order on a main surface side of a substrate made of silicon.
